(19) **Europäisches Patentamt / European Patent Office / Office européen des brevets**

(11) **EP 4 063 115 A1**

(12) **EUROPEAN PATENT APPLICATION**
published in accordance with Art. 153(4) EPC

(43) Date of publication:
**28.09.2022 Bulletin 2022/39**

(21) Application number: **20889375.0**

(22) Date of filing: **10.11.2020**

(51) International Patent Classification (IPC):
**B32B 9/00** (2006.01)        **B32B 27/36** (2006.01)
**B32B 27/40** (2006.01)        **B65D 65/02** (2006.01)
**B65D 65/40** (2006.01)        **B65D 81/34** (2006.01)

(52) Cooperative Patent Classification (CPC):
**B32B 9/00; B32B 27/36; B32B 27/40; B65D 65/02;
B65D 65/40; B65D 81/34;** Y02W 30/80

(86) International application number:
**PCT/JP2020/041936**

(87) International publication number:
**WO 2021/100558 (27.05.2021 Gazette 2021/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **20.11.2019   JP 2019209735**

(71) Applicant: **TOYOBO CO., LTD.
Osaka-shi, Osaka 530-8230 (JP)**

(72) Inventors:
 • **YAMAZAKI, Atsushi
   Inuyama-shi, Aichi 484-8508 (JP)**
 • **NUMATA, Yukihiro
   Inuyama-shi, Aichi 484-8508 (JP)**
 • **INAGAKI, Kyoko
   Osaka-shi Osaka 530-8230 (JP)**
 • **YAMAGUCHI, Yuya
   Osaka-shi Osaka 530-8230 (JP)**

(74) Representative: **Vossius & Partner
Patentanwälte Rechtsanwälte mbB
Siebertstraße 3
81675 München (DE)**

(54)     **LAYERED FILM**

(57)     The object of the present invention is to provide an environment-responsive laminated film including an inorganic thin film layer and a protective layer in this order on a substrate film layer using a polyester resin recycled from PET bottles. The laminated film has excellent barrier properties and adhesiveness even after a severe wet heat treatment such as retort sterilization and has less deterioration in the appearance of the film even after retorting.

The laminated film comprising:
a substrate film;
an inorganic thin film layer on at least one surface of the substrate film; and
a protective layer containing a urethane resin on the inorganic thin film layer,
wherein the laminated film satisfies the following requirements (a) to (c):
(a) the substrate film contains 50% by weight or more of a polyester resin recycled from PET bottles;
(b) standard deviation of a haze after retorting the laminated film at 130°C for 30 minutes is 0.5% or less; and
(c) an adhesion amount of the protective layer is 0.5 g/m$^2$ or less.

**Description**

TECHNICAL FIELD

The present invention relates to a laminated film used in the packaging fields of foods, pharmaceuticals, and industrial products and the like.

More specifically, the present invention relates to a laminated film including an inorganic thin film layer and a protective layer in this order on a substrate film layer using a polyester resin recycled from PET bottles. The laminated film has excellent barrier properties and adhesiveness, and has excellent gas barrier properties even if used for applications to be subjected to a severe wet heat treatment such as retort sterilization.

BACKGROUND ART

In recent years, regulations for reducing the use of disposable plastics have been strengthened in various countries including Europe. In this background, there are growing international awareness of resource circulation and aggravated waste problems in emerging countries. Therefore, for plastic packaging materials required for foods and pharmaceuticals and the like, environment-responsive products are required from the viewpoint of 3R (recycle, reuse, reduce).

Examples of performances required for the above-mentioned environmentally friendly packaging material include: the packaging material is made of a recycled material; the packaging material has gas barrier performance capable of blocking various gases and extending the best-before expiration date; and the packaging material has a material with a less environmental load (for example, no organic solvent is used, and the amount of the material used itself is small).

A polyester resin recycled from PET bottles is known as a typical recycled material, and a technique is known, in which a polyester film for a covering label having less trouble due to static electricity is formed of a polyester resin derived from PET bottles having a small oligomer content without deteriorating productivity and quality (see, for example, Patent Document 1). As environmental regulations increase in the future, demand for such film applications is expected to increase.

On the other hand, in food applications requiring blocking of various gases such as water vapor and oxygen, a gas barrier laminated body in which a metal thin film made of aluminum or the like, and an inorganic thin film made of an inorganic oxide such as silicon oxide or aluminum oxide are formed on the surface of a substrate film made of plastic is generally used. Among them, a laminated body in which a thin film made of an inorganic oxide (inorganic thin film layer) such as silicon oxide, aluminum oxide, or a mixture thereof is formed does not require the use of aluminum foil and is transparent, whereby the contents thereof can be confirmed. Therefore, the laminated film is widely used.

For the gas barrier film composed of the recycled material and the inorganic thin film as described above, a laminated film exhibiting good gas barrier properties when formed as a gas barrier laminated film including an inorganic thin film layer and a sealant layer has been proposed. The laminated film contains a polyester resin recycled from PET bottles, and has low heat shrink properties and small thickness unevenness (for example, Patent Document 2). However, in such conventional techniques, interfacial adhesiveness after a sterilization treatment such as retorting capable of extending the best-before expiration date has not been examined, and barrier performance after retorting has not been examined.

As means for maintaining barrier properties and adhesiveness even after retorting, it has been reported that a coating layer composed of an oxazoline group-containing water-soluble polymer is provided between a substrate film and an inorganic thin film layer formed by, for example, a vapor-deposition method (see, for example, Patent Document 3). The provision of the coating layer between the substrate film and the inorganic thin film can also be continuously performed while a film of the substrate is formed. Thus, it can be expected that the provision makes costs far lower than the formation of the protective layer on the inorganic thin film. However, in the case of the above constitution, the coating layer itself has no gas barrier properties so that only the inorganic thin film layer mainly contributes to the gas barrier properties, whereby the constitution has a problem that the laminated body is not sufficient in gas barrier properties.

Against this problem, an attempt has been made in which a protective layer having gas barrier properties is further provided on an inorganic thin film. Suggested has been, for example, a method in which a water-soluble polymer, an inorganic lamellar compound, and a metal alkoxide or a hydrolyzate thereof are coated on an inorganic thin film to form a composite of an inorganic substance containing the inorganic lamellar compound and the water-soluble polymer on the inorganic thin film by a sol-gel method, and a laminated body in which an inorganic thin film is coated with a metaxylylene group-containing polyurethane (see, for example, Patent Document 4).

By providing the coating layer, the inorganic thin film layer, and the protective layer, barrier performance after retorting and adhesiveness at the interface of the layers when the laminated body is formed can be maintained, but the substrate and the coating material are not used in consideration of those having a small environmental load, whereby there is a concern that a load on the environment is large. Furthermore, film whitening at the time of retorting at a high temperature has not been examined. That is, when the film is exposed to a high temperature, the film is whitened due to oligomer deposition in the substrate or unevenness deformation of the coating and protective layers, which may adversely affect the appearance and printability. In particular, the present inventors have found that when a resin derived from PET bottles is used to form a film, the original haze may be high, and the haze value further increases after retorting.

PRIOR ART DOCUMENTS

PATENT DOCUMENT

Patent Document 1: JP-A-2012-91862
Patent Document 2: JP-B-6500629
Patent Document 3: JP-B-5560708
Patent Document 4: JP-B-4524463

SUMMARY OF THE INVENTION

PROBLEMS TO BE SOLVED BY THE INVENTION

In Patent Document 2 described above, gas barrier properties and adhesiveness after a severe wet heat treatment such as retort have not been examined. In Patent Document 3 described above, gas barrier performance has been insufficient. In Patent Document 4 described above, deterioration in the appearance of the film after retorting has not been examined.

The present invention has been made in view of the problems of the conventional techniques.

That is, an object of the present invention is to provide an environment-responsive laminated film including an inorganic thin film layer and a protective layer in this order on a substrate film layer using a polyester resin recycled from PET bottles. The laminated film has excellent barrier properties and adhesiveness even after a severe wet heat treatment such as retort sterilization and has less deterioration in the appearance of the film even after retorting.

MEANS FOR SOLVING THE PROBLEMS

The present inventors have found that by forming a laminated film having a constitution in which an inorganic thin film layer is sandwiched between specific coating layers or specific barrier protective layers having excellent flexibility and adhesiveness, gas barrier performance before a treatment can be improved, and the barrier properties and adhesiveness of the laminated film can be maintained even after a severe wet heat treatment. The present inventors further have found that the use of a polyester resin derived from PET bottles having a low environmental load as a substrate provides less whitening after retorting, and have completed the present invention.

That is, the present invention comprises the following components.

(1) A laminated film comprising:

a substrate film;
an inorganic thin film layer on at least one surface of the substrate film; and
a protective layer containing a urethane resin on the inorganic thin film layer,
wherein the laminated film satisfies the following requirements (a) to (c):

(a) the substrate film contains 50% by weight or more of a polyester resin recycled from PET bottles;
(b) standard deviation of a haze after retorting the laminated film at 130°C for 30 minutes is 0.5% or less; and
(c) an adhesion amount of the protective layer is 0.5 $g/m^2$ or less.

(2) The laminated film according to (1), wherein the protective layer contains an aromatic component or an aromatic-aliphatic component as a constituent component.
(3) The laminated film according to (1) or (2), wherein the protective layer contains a meta-xylylene diisocyanate component as a constituent component.
(4) The laminated film according to any one of (1) to (3), further comprising a coating layer between the substrate film layer and the inorganic thin film layer,
wherein the coating layer contains a resin having an oxazoline group or a carbodiimide group as a constituent component.

(5) The laminated film according to any one of (1) to (4), wherein the inorganic thin film layer is an aluminum oxide or a layer of a composite oxide of silicon oxide and aluminum oxide.

(6) A packaging material obtained by laminating a sealant layer on one surface of the laminated film according to any one of (1) to (5).

EFFECT OF THE INVENTION

The present invention makes it possible to provide a laminated film that has excellent barrier properties and adhesiveness even after a severe wet heat treatment such as retort sterilization while using a recycled material, and has less deterioration in the appearance of the film even after retorting.

MODE FOR CARRYING OUT THE INVENTION

The following is a detailed description of the present invention.

[Substrate Film Layer]

In the present invention, as described later, a recycled polyester resin regenerated from PET bottles containing an isophthalic acid component as an acid component is preferably used as a raw material for a substrate film. Therefore, the substrate film is composed of a mixed resin of a recycled polyester resin and a virgin raw material, that is, an unrecycled resin, and the intrinsic viscosity of the resin constituting the film means a value obtained by measuring the intrinsic viscosity of the mixed resin constituting the film. The lower limit of the intrinsic viscosity of the resin constituting the film obtained by measuring the substrate film is preferably 0.58 dl/g, and more preferably 0.60 dl/g. When the intrinsic viscosity is less than 0.58 dl/g, the intrinsic viscosity of the recycled resin composed of PET bottles often exceeds 0.68 dl/g, and when the viscosity is reduced at the time of producing a film using the recycled resin, poor thickness unevenness may occur, which is not preferable. The film may be colored, which is not preferable. The upper limit is preferably 0.70 dl/g, and more preferably 0.68 dl/g. When the intrinsic viscosity exceeds 0.70 dl/g, the resin is less likely to be discharged from an extruder, whereby the productivity may be lowered, which is not preferable.

The lower limit of the thickness of the substrate film is preferably 8 $\mu$m, more preferably 10 $\mu$m, and still more preferably 12 $\mu$m. If the thickness is less than 8 $\mu$m, the strength of the film may be insufficient, which is not preferable. The upper limit is preferably 200 $\mu$m, more preferably 50 $\mu$m, and still more preferably 30 $\mu$m. If the thickness exceeds 200 $\mu$m, the film becomes too thick, which may cause difficult processing. It is not preferable that the thickness of the film increases from the viewpoint of an environmental load, and it is preferable to reduce the volume as much as possible.

The lower limit of the refractive index of the substrate film in the thickness direction is preferably 1.4930, and more preferably 1.4940. If the refractive index is less than 1.4930, orientation is not sufficient, and therefore a lamination strength may not be obtained. The upper limit is preferably 1.4995 and more preferably 1.4980. If the refractive index exceeds 1.4995, the orientation of the plane may collapse to cause insufficient mechanical characteristics, which is not preferable.

The lower limit of the heat shrinkage rate of the substrate film treated at 150°C for 30 minutes in the machine direction (sometimes referred to as MD) and the transverse direction (sometimes referred to as TD) is preferably 0.1%, and more preferably 0.3%. If the heat shrinkage rate is less than 0.1%, the improvement effect may be saturated, and the film may be mechanically brittle, which is not preferable. The upper limit is preferably 3.0%, and more preferably 2.5%. If the heat shrinkage rate exceeds 3.0%, pitch deviation and the like may occur due to dimensional change during processing such as printing, which is not preferable. If the heat shrinkage rate exceeds 3.0%, shrinkage and the like in the transverse direction may occur due to dimensional change during processing such as printing, which is not preferable.

A recycled polyester resin derived from PET bottles containing an isophthalic acid component as an acid component is preferably used as a raw material for a substrate film. The crystallinity of a polyester used for PET bottles is controlled in order to improve the bottle appearance, and as a result, a polyester containing 10 mol% or less of an isophthalic acid component may be used. In order to utilize a recycled resin, a material containing an isophthalic acid component may be used.

The lower limit of the amount of a terephthalic acid component in all dicarboxylic acid components constituting the polyester resin contained in the substrate film is preferably 95.0 mol%, more preferably 96.0 mol%, still more preferably 96.5 mol%, and particularly preferably 97.0 mol%. If the amount is less than 95.0 mol%, crystallinity is deteriorated, whereby the heat shrinkage rate may increase, which is not so preferable. The upper limit of the amount of the terephthalic acid component in the polyester resin contained in the film is preferably 99.5 mol%, and more preferably 99.0 mol%. Many of the recycled polyester resins derived from PET bottles contain dicarboxylic acid components typified by isophthalic acid besides terephthalic acid, whereby the amount of the terephthalic acid component constituting the polyester resin in the film exceeding 99.5 mol% consequently makes it difficult to produce a polyester film containing a recycled resin at a high rate, which is not so preferable.

The lower limit of the amount of the isophthalic acid component in all the dicarboxylic acid components constituting the polyester resin contained in the substrate film is preferably 0.5 mol%, more preferably 0.7 mol%, still more preferably 0.9 mol%, and particularly preferably 1.0 mol%. Recycled polyester resins derived from PET bottles contain a large amount of an isophthalic acid component, whereby the amount of the isophthalic acid component constituting the polyester resin in the film of less than 0.5 mol% consequently makes it difficult to produce a polyester film containing a recycled resin at a high rate, which is not so preferable. The upper limit of the amount of the isophthalic acid component in all the dicarboxylic acid components constituting the polyester resin contained in the film is preferably 5.0 mol%, more preferably 4.0 mol%, still more preferably 3.5 mol%, and particularly preferably 3.0 mol%. If the amount exceeds 5 mol%, crystallinity is deteriorated, whereby the heat shrinkage rate may increase, which is not so preferable. When the content rate of the isophthalic acid component is within the above range, a film having an excellent lamination strength, an excellent shrinkage rate, and reduced thickness unevenness can be easily produced, which is preferable.

The upper limit of the intrinsic viscosity of the recycled resin derived from PET bottles is preferably 0.90 dl/g, more preferably 0.80 dl/g, still more preferably 0.77 dl/g, and particularly preferably 0.75 dl/g. If the intrinsic viscosity exceeds 0.9 dl/g, the resin is less likely to be discharged from an extruder, whereby the productivity may be lowered, which is not so preferable.

The lower limit of the content rate of the polyester resin recycled from PET bottles in the film is preferably 50% by weight, more preferably 65% by weight, and still more preferably 75% by weight. If the content rate is less than 50% by weight, the content rate is low for utilization of the recycled resin, which is not so preferable in terms of contribution to environmental protection. Since the recycled resin is produced by solid phase polymerization, the content of oligomers that may cause film whitening is small. Therefore, as the content rate of the recycled resin is higher, the whitening of the film after retorting tends to be improved. When the content rate of the recycled resin is less than 50%, there is a concern that the whitening unevenness of the film after retorting is promoted. Meanwhile, the upper limit of the content rate of the polyester resin recycled from PET bottles is 100% by weight, preferably 99% by weight, more preferably 95% by weight, still more preferably 90% by weight, and particularly preferably 85% by weight. If the content rate exceeds 95% by weight, it is sometimes impossible to sufficiently add a lubricant or an additive such as inorganic particles for improving the function as a film, which is not so preferable. A polyester resin recycled from PET bottles may be used as a master batch (a resin contained in a high concentration) used when a lubricant or an additive such as inorganic particles is added for improving the function as a film.

As the kind of the lubricant, inorganic lubricants such as silica, calcium carbonate, and alumina, and also organic lubricants are preferable, and silica and calcium carbonate are more preferable. By these lubricants, transparency and slippage can be exhibited.

The lower limit of the lubricant content rate in the substrate film is preferably 0.01% by weight, more preferably 0.015% by weight, and still more preferably 0.02% by weight. If the content rate is less than 0.01% by weight, the slippage may be deteriorated. The upper limit of the lubricant content rate is preferably 1% by weight, more preferably 0.2% by weight, and still more preferably 0.1% by weight. If the lubricant content rate exceeds 1% by weight, transparency may be deteriorated, which is not so preferable.

A method for producing the substrate film used in the laminated film of the present invention is not particularly limited, but for example, the following production method is recommended. It is important to set a temperature for melting and extruding a resin in an extruder. The basic idea is that (1) deterioration is suppressed by extrusion at a temperature as low as possible, since a polyester resin used for PET bottles contains an isophthalic acid component, and (2) the polyester resin has a portion that melts at a high temperature or a high pressure or the like in order to sufficiently and uniformly melt an intrinsic viscosity or a fine highly crystalline portion. Addition of the isophthalic acid component leads to deterioration in the tacticity of a polyester and a decrease in the melting point. Therefore, extrusion at a high temperature results in a significant decrease in melt viscosity or deterioration by heat, and also in a decrease in the mechanical strength and an increase in foreign matters resulting from the deterioration. Sufficient melt-kneading is impossible merely by lowering the extrusion temperature, which may result in problems of an increase in thickness unevenness and foreign matters such as fish eyes. From the above, examples of a recommended production method include a method of using two extruders in tandem, a method of increasing the pressure in a filter part, or a method of using a screw having a high shear force for a part of a screw constitution.

The lower limit of the set temperature of the resin melting part in the extruder (excluding the maximum set temperature of the compression part of the screw in the extruder) is preferably 270°C, and the upper limit thereof is preferably 290°C. If the set temperature is lower than 270°C, extrusion is difficult, and if the temperature exceeds 290°C, the resin may be deteriorated, which is not so preferable.

The lower limit of the highest set temperature in the compression part of the screw in the extruder is preferably 295°C. In a polyester resin used for PET bottles, crystals having a high melting point (260°C to 290°C) often exist in terms of transparency. An additive and a crystallization nucleating agent and the like are added, and unevenness in the fine melting behavior is observed in the resin material. If the highest set temperature is lower than 295°C, it is difficult to sufficiently melt them, which is not so preferable. The upper limit of the highest set temperature in the compression part of the screw in the extruder is preferably 310°C. If the highest set temperature exceeds 310°C, the resin may be deteriorated, which is not so preferable.

The lower limit of the time for the resin to pass the region at the highest set temperature in the compression part of the screw in the extruder is preferably 10 seconds, and more preferably 15 seconds. If the time is shorter than 10 seconds, the polyester resin used for PET bottles cannot be sufficiently melted, which is not so preferable. The upper limit of the time is preferably 60 seconds, and more preferably 50 seconds. If the time exceeds 60 seconds, the resin is apt to be deteriorated, which is not so preferable. By setting the extruder in such ranges, a film reduced in thickness unevenness, foreign matters such as fish eyes, and coloration can be obtained even if a large amount of a polyester resin recycled from PET bottles is used.

The resin melted in this manner is extruded in a sheet-like form on a cooling roll, and then biaxially stretched. The stretching method may be a simultaneous biaxial stretching method, but a sequential biaxial stretching method is particularly preferable. These make it easy to satisfy productivity and quality required in the present invention.

A method for stretching the film in the present invention is not particularly limited, but the following points are important. In order to stretch a resin having an intrinsic viscosity of 0.58 dl/g or more and containing an isophthalic acid component, ratios and temperatures in the machine direction (MD) stretching and transverse direction (TD) stretching are important. If the MD stretch ratio and the temperature are not appropriate, a stretching force is not uniformly applied, and the orientation of molecules is insufficient, which may result in an increase in thickness unevenness or insufficient mechanical characteristics. The film may be broken in the next TD stretching step, or thickness unevenness may be extremely increased. If the TD stretch ratio and the temperature are not appropriate, the film may not be uniformly stretched; balance of the vertical and transverse orientation may be deteriorated; and the mechanical characteristics may be insufficient. When the next heat setting step is performed in the state that the thickness unevenness is significant or the molecular chain orientation is insufficient, relaxation cannot be uniformly performed, which causes problems of more significant thickness unevenness and insufficient mechanical characteristics. Therefore, it is basically recommended that in the MD stretching, stretching is performed step by step by performing temperature adjustment described below, and in the TD stretching, stretching is performed at an appropriate temperature so that the orientation balance is not extremely deteriorated. The present invention is not limited to the following aspects, but will be described with an example.

A machine direction (MD) stretching method is preferably a roll stretching method or an IR heating method.

The lower limit of the MD stretching temperature is preferably 100°C, more preferably 110°C, and still more preferably 120°C. Even if the MD stretching temperature is lower than 100°C, and a polyester resin with an intrinsic viscosity of 0.58 dl/g or more is stretched to orient molecules in the machine direction, the film is broken in the next transverse stretching step or an extreme thickness defect is caused, which is not preferable. The upper limit of the MD stretching temperature is preferably 140°C, more preferably 135°C, and still more preferably 130°C. If the MD stretching temperature exceeds 140°C, the orientation of molecular chains becomes insufficient, whereby mechanical characteristics may become insufficient, which is not so preferable.

The lower limit of the MD stretch ratio is preferably 2.5 times, more preferably 3.5 times, and still more preferably 4 times. Even if the MD stretch ratio is less than 2.5 times, and a polyester resin having an intrinsic viscosity of 0.58 dl/g or more is stretched to orient molecules in the machine direction, the film may be broken in the next transverse stretching step or an extreme thickness defect may be caused, which is not so preferable. The upper limit of the MD stretch ratio is preferably 5 times, more preferably 4.8 times, and still more preferably 4.5 times. If the MD stretch ratio exceeds 5 times, the effect of improving a mechanical strength and thickness unevenness may be saturated, which is not so meaningful.

The MD stretching method may be the above-mentioned one-stage stretching, but the film is preferably stretched in two or more stages. Stretching in two or more stages makes it possible to well stretch a polyester resin having a high intrinsic viscosity and derived from a recycled resin containing isophthalic acid, which provides reduced thickness unevenness, and an improved lamination strength and mechanical characteristics.

The lower limit of the MD stretching temperature in the first stage is preferably 110°C, and more preferably 115°C. If the MD stretching temperature is lower than 110°C, heat is insufficient, whereby vertical stretching cannot be sufficiently performed, resulting in poor flatness, which is not preferable. The upper limit of the MD stretching temperature in the first stage is preferably 125°C, and more preferably 120°C. If the MD stretching temperature exceeds 125°C, the orientation of molecular chains may become insufficient and mechanical characteristics may be deteriorated, which is not so preferable.

The lower limit of the MD stretch ratio in the first stage is preferably 1.1 times, and more preferably 1.3 times. If the MD stretch ratio is 1.1 times or more, finally, a polyester resin having an intrinsic viscosity of 0.58 dl/g or more can be sufficiently stretched in the machine direction by weak stretching in the first stage, and accordingly, the productivity can be improved. The upper limit of the MD stretch ratio in the first stage is preferably 2 times, and more preferably 1.6 times. If the MD stretch ratio exceeds 2 times, the orientation of molecular chains in the machine direction is too high, whereby the stretching may become difficult in the second stage or thereafter and the film may have significant thickness unevenness, which is not so preferable.

The lower limit of the MD stretching temperature in the second stage (or final stage) is preferably 110°C, and more preferably 115°C. If the MD stretching temperature is 110°C or higher, a polyester resin having an intrinsic viscosity of 0.58 or more can be sufficiently stretched in the machine direction and can be stretched in the transverse direction in the next step, so that the thickness unevenness in the vertical and transverse directions can be reduced. The upper limit of the MD stretching temperature is preferably 130°C, and more preferably 125°C. If the MD stretching temperature exceeds 130°C, crystallization is promoted, whereby the transverse stretching may become difficult or the thickness unevenness may become significant, which is not so preferable.

The lower limit of the MD stretch ratio in the second stage (or final stage) is preferably 2.1 times, and more preferably 2.5 times. Even if the MD stretch ratio is less than 2.1 times, and a polyester resin having an intrinsic viscosity of 0.58 or more is stretched to orient molecules in the machine direction, the film may be broken in the next transverse stretching step or an extreme thickness defect may be caused, which is not so preferable. The upper limit of the MD stretch ratio is preferably 3.5 times, and more preferably 3.1 times. If the MD stretch ratio exceeds 3.5 times, the orientation in the machine direction is too high, whereby the stretching may be impossible in the second stage or thereafter and the film may have significant thickness unevenness, which is not so preferable.

The lower limit of the TD stretching temperature is preferably 110°C, more preferably 120°C, and still more preferably 125°C. If the TD stretching temperature is lower than 110°C, the stretching stress in the transverse direction is increased, whereby the film may be broken or the thickness unevenness may become extremely significant, which is not so preferable. The upper limit of the TD stretching temperature is preferably 150°C, more preferably 145°C, and still more preferably 140°C. If the TD stretching temperature exceeds 150°C, the orientation of molecular chains does not increase, whereby mechanical characteristics may be deteriorated, which is not so preferable.

The lower limit of the transverse direction (TD) stretch ratio is preferably 3.5 times, and more preferably 3.9 times. If the stretch ratio is less than 3.5 times, molecular orientation is weak, whereby a mechanical strength may become insufficient, which is not so preferable. The orientation of molecular chains in the machine direction is significant and the balance between the vertical and transverse directions is deteriorated to make the thickness unevenness significant, which is not so preferable. The upper limit of the TD stretch ratio is preferably 5.5 times, and more preferably 4.5 times. If the TD stretch ratio exceeds 5.5 times, the film may be broken, which is not so preferable.

In order to obtain the substrate film used for the laminated film of the present invention, it is desirable to appropriately set conditions for heat setting continuously performed in a tenter after the completion of the TD stretching and for the subsequent cooling of the film to room temperature. As compared with a common polyethylene terephthalate film containing no isophthalic acid, a polyester film containing a recycled resin derived from PET bottles and containing isophthalic acid has low crystallinity, is apt to be melted in an ultra-fine level, and has a poor mechanical strength. Therefore, when the polyester film is exposed to high temperatures under strain abruptly after completion of stretching, or when the polyester film is abruptly cooled under strain after completion of heat setting at high temperatures, a tensile force balance in the transverse direction is disordered due to an inevitable temperature difference in a film transverse direction, which results in thickness unevenness and defective mechanical characteristics. Meanwhile, when the heat setting temperature is lowered to deal with the phenomenon, a sufficient lamination strength may not be obtained. In the present invention, it is recommended to perform steps of heat setting 1 at a slightly low temperature, heat setting 2 (as necessary, heat setting 3) at a sufficiently high temperature, and thereafter, gradual cooling to lower the temperature to room temperature after the completion of stretching. However, the present invention is not limited to this method, and other recommended methods include a method of controlling the film tension correspondingly to the velocity of hot air in the tenter and the temperatures in the respective zones; a method of performing heat treatment at a relatively low temperature in a furnace with a sufficient length after the completion of stretching; and a method of relaxing the film by heat rolls after the completion of the heat setting.

As one example, a method by controlling the tenter temperature will be described. Heat settings 1, 2, and 3 are arranged in order from the upstream side in the film machine direction of ae heat setting zone in the tenter.

The lower limit of the temperature in the heat setting 1 is preferably 160°C, and more preferably 170°C. If the temperature is lower than 160°C, the heat shrinkage rate finally increases, and deviation and shrinkage may be caused at the time of processing, which is not so preferable. The upper limit of the temperature is preferably 215°C, and more preferably 210°C. If the temperature exceeds 215°C, the film is abruptly exposed to a high temperature, whereby the thickness unevenness may become significant or the film may be broken, which is not so preferable.

The lower limit of the time for the heat setting 1 is preferably 0.5 seconds, and more preferably 2 seconds. If the time is shorter than 0.5 sec, the film temperature increase may be insufficient. The upper limit of the time is preferably 10 seconds, and more preferably 8 seconds. If the time exceeds 10 seconds, productivity may be deteriorated, which is not so preferable.

The lower limit of the temperature in the heat setting 2 is preferably 220°C, and more preferably 227°C. If the temperature is lower than 220°C, the heat shrinkage rate may become significant, whereby deviation and shrinkage may be caused at the time of processing, which is not so preferable. The upper limit of the temperature is preferably 240°C, and more preferably 237°C. If the temperature exceeds 240°C, the film may be melted, or even if not melted, the film may be fragile, which is not so preferable.

The lower limit of the time for the heat setting 2 is preferably 0.5 seconds, and more preferably 3 seconds. If the time is shorter than 0.5 seconds, the film may be apt to be broken at the time of heat setting, which is not so preferable. The upper limit of the time is preferably 10 seconds, and more preferably 8 seconds. If the upper limit of the time exceeds 10 seconds. sagging may occur to result in thickness unevenness, which is not so preferable.

The lower limit of the temperature in the case where the heat setting 3 is performed as necessary is preferably 205°C, and more preferably 220°C. If the temperature is lower than 205°C, the heat shrinkage rate may become significant, and deviation whereby shrinkage may be caused at the time of processing, which is not so preferable. The upper limit of the temperature is preferably 240°C, and more preferably 237°C. If the temperature exceeds 240°C, the film may be melted, or even if not melted, the film may be fragile, which is not so preferable.

The lower limit of the time in the case where the heat setting 3 is performed as necessary is preferably 0.5 seconds, and more preferably 3 seconds. If the time is shorter than 0.5 seconds, the film may be apt to be broken at the time of heat setting, which is not so preferable. The upper limit of the time is preferably 10 seconds, and more preferably 8 seconds. If the time exceeds 10 seconds, sagging may occur to cause thickness unevenness, which is not so preferable.

TD relaxation may be carried out at any point in the heat setting. The lower limit thereof is preferably 0.5%, and more preferably 3%. If the lower limit is less than 0.5%, the heat shrinkage rate particularly in the transverse direction becomes significant, whereby deviation and shrinkage may be caused at the time of processing, which is not so preferable. The upper limit thereof is preferably 10%, and more preferably 8%. If the upper limit exceeds 10%, sagging may occur to cause thickness unevenness, which is not so preferable.

The lower limit of the gradual cooling temperature after the TD heat setting is preferably 90°C, and more preferably 100°C. If the gradual cooling temperature is lower than 90°C, the film contains isophthalic acid, whereby the thickness unevenness may become significant because of shrinkage by abrupt temperature change or the film may be broken, which is not so preferable. The upper limit of the gradual cooling temperature is preferably 150°C, and more preferably 140°C. If the gradual cooling temperature exceeds 150°C, a sufficient cooling effect may not be obtained, which is not so preferable.

The lower limit of the gradual cooling time after the heat setting is preferably 2 seconds, and more preferably 4 seconds. If the gradual cooling time is shorter than 2 seconds, a sufficient gradual cooling effect may not be obtained, which is not so preferable. The upper limit thereof is preferably 20 seconds, and more preferably 15 seconds. The gradual cooling time exceeding 20 seconds is apt to be disadvantageous in terms of productivity, which is not so preferable.

The upper limit of the haze per thickness of the substrate film layer in the present invention is preferably 0.66%/$\mu$m, more preferably 0.60%/$\mu$m, and still more preferably 0.53%/$\mu$m. When the substrate film layer having a haze of 0.66%/$\mu$m or less is subjected to printing, the quality of printed characters and images is improved.

The substrate film layer in the present invention may be subjected to corona discharge treatment, glow discharge treatment, flame treatment, or surface roughening treatment, as long as the object of the present invention is not impaired, and may be subjected to known anchor coating treatment, printing, or decoration or the like.

A layer made of another material may be laminated on the substrate film layer in the present invention. As the method, the layer may be laminated on the substrate film layer after or during the production of the substrate film layer.

[Inorganic Thin Film Layer]

In the laminated film having gas barrier properties of the present invention, an inorganic thin film layer is provided on the surface of the substrate film. The inorganic thin film layer is a thin film made of a metal or an inorganic oxide. The material for forming the inorganic thin film layer is not particularly limited as long as the material can be made into a thin film, but from the viewpoint of gas barrier properties, inorganic oxides such as silicon oxide (silica), aluminum oxide (alumina), and mixtures of silicon oxide and aluminum oxide are preferable. In particular, a composite oxide of silicon oxide and aluminum oxide is preferable from the viewpoint that both flexibility and denseness of the thin film layer can be achieved. In this composite oxide, silicon oxide and aluminum oxide are preferably mixed at such a mixing ratio that the concentration of Al is within a range of 20 to 70% by mass in terms of metal content by mass. If the concentration of Al is less than 20% by mass, the barrier properties against water vapor may be deteriorated. Meanwhile, If the concentration of Al exceeds 70% by mass, the inorganic thin film layer tends to be harder, whereby the film may be broken during secondary processing such as printing or lamination to cause deteriorated gas barrier properties. The silicon oxide as used herein is various silicon oxides such as SiO and $SiO_2$, or a mixture thereof, and the aluminum oxide as used herein is various aluminum oxides such as AlO and $Al_2O_3$, or a mixture thereof.

The film thickness of the inorganic thin film layer is normally 1 to 100 nm, and preferably 5 to 50 nm. If the film thickness of the inorganic thin film layer is less than 1 nm, satisfactory gas barrier properties may be less likely to be obtained. Meanwhile, even if the film thickness exceeds 100 nm such that the inorganic thin film layer is excessively thickened, the gas barrier properties-improving effect equivalent to such increase in the thickness cannot be obtained, and such a film thickness is rather disadvantageous in terms of flex resistance and production cost.

The method for forming the inorganic thin film layer is not particularly limited, and known vapor-deposition methods, for example, physical vapor-deposition methods (PVD methods) such as a vacuum vapor-deposition method, a sputtering method, and an ion plating method, or chemical vapor-deposition methods (CVD methods) may be adopted as appropriate. Hereinafter, a typical method for forming the inorganic thin film layer will be described by taking a silicon oxide-aluminum oxide based thin film as an example. For example, in the ease of adopting a vacuum vapor-deposition method, a mixture of $SiO_2$ and $Al_2O_3$, or a mixture of $SiO_2$ and Al, or the like is preferably used as a vapor-deposition raw material. Normally, particles are used as these vapor-deposition raw materials. In this case, the size of each particle is desirably a size that does not change the pressure during vapor-deposition, and a preferable particle size is 1 mm to 5 mm. For heating, systems such as resistive heating, high frequency induction heating, electron beam heating, and laser heating can be adopted. It is also possible to adopt reactive vapor-deposition in which oxygen, nitrogen, hydrogen, argon, carbon dioxide gas, or water vapor or the like is introduced as a reaction gas or a means such as ozone addition or ion assist is used. Furthermore, film production conditions such as applying a bias to a body to be vapor-deposited (laminated film to be vapor-deposited) and heating or cooling the body to be vapor-deposited can also be optionally changed. Similarly, the vapor-deposition materials, the reaction gases, the application of a bias to the body to be vapor-deposited, and the heating/cooling and the like can be changed even when a sputtering method or a CVD method is adopted.

[Coating Layer]

In the laminated film of the present invention, a coating layer can be provided between the substrate film layer and the inorganic thin film layer for the purpose of securing gas barrier properties after retorting and a lamination strength. Examples of the resin composition used for the coating layer provided between the substrate film layer and the inorganic thin film layer include compositions obtained by adding epoxy-based, isocyanate-based, melamine-based, oxazoline-based, and carbodiimide-based curing agents and the like to urethane-based, polyester-based, acryl-based, titanium-based, isocyanate-based, imine-based, and polybutadiene-based resins and the like. These resin compositions used for the coating layer preferably contain a silane coupling agent having at least one or more organic functional groups. The organic functional groups include alkoxy groups, amino groups, epoxy groups, isocyanate groups, etc. By the addition of the silane coupling agent, the lamination strength after retorting is further improved.

Among the resin compositions used for the coating laye, a mixture of a resin containing an oxazoline group or a carbodiimide group, an acrylic resin, and a urethane-based resin is preferably used. These functional groups have high affinity with the inorganic thin film, and can react with a metal hydroxide and an oxygen deficiency portion of an inorganic oxide that is generated during formation of the inorganic thin film layer, whereby firm adhesion to the inorganic thin film layer is exhibited. An unreacted functional group present in a coating layer can react with a carboxylic acid terminal that is generated by hydrolysis of the substrate film layer and the coating layer, thereby forming cross-links.

In the present invention, the adhesion amount of the coating layer is preferably 0.010 to 0.200 ($g/m^2$). This makes it possible to uniformly control the coating layer, and as a result, the inorganic thin film layer can be densely deposited. The cohesive force inside the coating layer is improved, and the adhesion between the respective layers of the substrate film-coating layer -inorganic thin film layer is also improved, whereby the water-resistant adhesiveness of the coating layer can be improved. The adhesion amount of the coating layer is preferably 0.015 ($g/m^2$) or more, more preferably 0.020 ($g/m^2$) or more, and still more preferably 0.025 ($g/m^2$) or more, and preferably 0.190 ($g/m^2$) or less, more preferably 0.180 ($g/m^2$) or less, and still more preferably 0.170 ($g/m^2$) or less. If the adhesion amount of the coating layer exceeds 0.200 ($g/m^2$), the cohesive force inside the coating layer becomes insufficient, whereby good adhesion may not be exhibited. Since the uniformity of the coating layer is also deteriorated, defects occur in the inorganic thin film layer, whereby the gas barrier properties may be deteriorated. Moreover, the production cost increases, which is economically disadvantageous. Meanwhile, if the film thickness of the coating layer is less than 0.010 ($g/m^2$), the substrate cannot be sufficiently coated, whereby sufficient gas barrier properties and interlayer adhesion may not be obtained.

The method for forming the coating layer is not particularly limited, and, for example, conventionally known methods such as coating methods can be adopted. Examples of suitable methods among the coating methods include an off-line coating method and an in-line coating method. For example, in the case of an in-line coating method that is performed in a step of producing a substrate film layer, as conditions for drying and a heat treatment during coating, although depending on a coating thickness or conditions of an apparatus, it is preferable to send the substrate film to a stretching step in a perpendicular direction immediately after coating and to perform drying in a pre-heating zone or a stretching zone in the stretching step. In such a case, normally, the temperature is preferably set to about 50 to 250°C.

Examples of the solvent (solvating medium) used when the coating method is used include aromatic solvents such as benzene and toluene; alcohol-based solvents such as methanol and ethanol; ketone-based solvents such as acetone and methyl ethyl ketone; ester-based solvents such as ethyl acetate and butyl acetate; and polyhydric alcohol derivatives such as ethylene glycol monomethyl ether.

[Protective Layer]

In the present invention, a protective layer is provided on the inorganic thin film layer. The metal oxide layer is not a completely dense film, but has minute deficient portions dotted therein. By applying a specific resin composition for a protective layer described later onto the metal oxide layer to form a protective layer, the resin contained in the resin composition for a protective layer penetrates into the deficient portions of the metal oxide layer, which accordingly provides an effect of stabilizing the gas barrier properties. In addition, by using a material having gas barrier properties also for the protective layer itself, the gas barrier performance of the laminated film may also be significantly improved. Furthermore, the barrier layer prevents the intrusion of hot water into the substrate, and as a result, film whitening after retorting described later can also be reduced.

In the present invention, the adhesion amount of the protective layer is 0.50 $(g/m^2)$ or less, preferably 0.10 to 0.40 $(g/m^2)$. This makes it possible to uniformly control the protective layer in coating, resulting in a film having less coating unevenness and defects. The cohesive force of the protective layer itself is improved, and the adhesion between the inorganic thin film layer and the protective layer is also firm. Furthermore, the protective layer contributes to the suppression of the appearance of oligomers, and the haze after retorting is stabilized. The adhesion amount of the protective layer is preferably 0.13 $(g/m^2)$ or more, more preferably 0.16 $(g/m^2)$ or more, and still more preferably 0.19 $(g/m^2)$ or more, and preferably 0.37 $(g/m^2)$ or less, more preferably 0.34 $(g/m^2)$ or less, and still more preferably 0.31 $(g/m^2)$ or less. If the adhesion amount of the protective layer exceeds 0.400 $(g/m^2)$, the gas barrier properties are improved, but the cohesive force inside the protective layer is insufficient, and the uniformity of the protective layer is also deteriorated, whereby unevenness and defects may occur in the coating appearance, or the gas barrier properties and the adhesiveness may not be sufficiently exhibited. Meanwhile, if the film thickness of the protective layer is less than 0.10 $(g/m^2)$, sufficient gas barrier properties and interlayer adhesion may not be obtained.

As the resin composition used for the protective layer formed on the surface of the inorganic thin film layer of the laminated film of the present invention, resins such as a urethane-based resin, a polyester-based resin, an acryl-based resin, a titanium-based resin, an isocyanate-based resin, an imine-based resin, and a polybutadiene-based resin and the like can be used and curing agents such as an epoxy-based resin, an isocyanate-based resin, and a melamine-based resin may be further added.

In particular, the urethane resin is preferably contained because, in addition to barrier performance due to high cohesiveness of a urethane bond itself, a polar group interacts with the inorganic thin film layer and also has flexibility due to the presence of its amorphous portion, so that damage to the inorganic thin film layer can be suppressed even when a flexing load is applied. A polyester resin is also suitable because the same effect can be expected.

(Urethane Resin)

The glass transition temperature (Tg) of the urethane resin used in the present invention is preferably 100°C or higher, more preferably 110°C or higher, and still more preferably 120°C or higher from the viewpoint of improvement in the barrier properties due to the cohesive force. However, in order to exhibit an adhesion force, a flexible resin having excellent flexibility and a Tg of 100°C or lower may be mixed with the urethane resin. In that case, the addition ratio of the flexible resin is preferably within a range of 0 to 80%. The addition ratio is more preferably within a range of 10 to 70%, and still more preferably within a range of 20 to 60%. If the addition ratio is within the above range, both the cohesive force and the flexibility can be achieved, whereby the barrier properties and the adhesion are improved. If the addition ratio exceeds 80%, the film becomes too soft, which may lead to deterioration in barrier performance.

A urethane resin containing an aromatic or aromatic-aliphatic diisocyanate component as a main constituent component is more preferably used as the urethane resin from the viewpoint of improving the gas barrier properties thereof.

Among them, it is particularly preferable that the urethane resin contains a metaxylylene diisocyanate component. The use of the resin allows an effect of stacking between its aromatic rings to further increase the cohesive force of the urethane bonds. Consequently, good gas barrier properties are obtained.

In the present invention, the proportion of the aromatic or aromatic-aliphatic diisocyanate in the urethane resin is preferably set to 50 mol% or more (50 to 100 mol%) in 100 mol% of the polyisocyanate component (F). The total proportion of the aromatic or aromatic-aliphatic diisocyanate is preferably 60 to 100 mol%, more preferably 70 to 100 mol%, and still more preferably 80 to 100 mol%. As such resins, "TAKELAC (registered trademark) WPB" series commercially available from Mitsui Chemicals, Inc. can be suitably used. If the total proportion of the aromatic or aromatic-aliphatic diisocyanate is less than 50 mol%, good gas barrier properties may not be obtained.

In the urethane resin used in the present invention, various cross-linking agents such as a silicon-based cross-linking agent may be blended as long as the gas barrier properties are not impaired for the purpose of improving the cohesive force and the wet heat resistant adhesiveness of the film. Examples of the cross-linking agent include a silicon-based cross-linking agent, an oxazoline compound, a carbodiimide compound, and an epoxy compound. Among them, the water-resistant adhesiveness to the inorganic thin film layer can be particularly improved by blending a silicon-based cross-linking agent. From this viewpoint, a silicon-based cross-linking agent is particularly preferable. In addition, an oxazoline compound, a carbodiimide compound, and an epoxy compound and the like may be used in combination as the cross-linking agent.

As the silicon-based cross-linking agent, a silane coupling agent is preferable from the viewpoint of cross-linking between an inorganic substance and an organic substance. Examples of the silane coupling agent include hydrolyzable alkoxysilane compounds such as halogen-containing alkoxysilanes (chloro C2-4 alkyltri C1-4 alkoxysilanes such as 2-chloroethyltrimethoxysilane, 2-chloroethyltriethoxysilane, 3-chloropropyltrimethoxysilane, and 3-chloropropyltriethoxysilane), alkoxysilanes having an epoxy group [glycidyloxy C2-4 alkyltri C1-4 alkoxysilanes such as 2-glycidyloxyethyltrimethoxysilane, 2-glycidyloxyethyltriethoxysilane, 3-glycidyloxypropyltrimethoxysilane, and 3-glycidyloxypropyltriethoxysilane, glycidyloxy C2-4 alkyldi C1-4 alkoxysilanes such as 3-glycidyloxypropylmethyldimethoxysilane and 3-glycidyloxypropylmethyldiethoxysilane, (epoxycycloalkyl) C2-4 alkyltri C1-4 alkoxysilanes such as 2-(3,4-epoxycyclohexyl)ethyltrimethoxysilane, 2-(3,4-epoxycyclohexyl)ethyltriethoxysilane, and 3-(3,4-epoxycyclohexyl)propyltrimethoxysilane], alkoxysilanes having an amino group [amino C2-4 alkyltri C1-4 alkoxysilanes such as 2-aminoethyltrimethoxysilane, 3-aminopropyltrimethoxysilane, and 3-aminopropyltriethoxysilane, aminodi C2-4 alkyldi C1-4 alkoxysilanes such as 3-aminopropylmethyldimethoxysilane and 3-aminopropylmethyldiethoxysilane, (2-amino C2-4 alkyl)amino C2-4 alkyltri C1-4 alkoxysilanes such as 2-[N-(2-aminoethyl)amino]ethyltrimethoxysilane, 3-[N-(2-aminoethyl)amino]propyltrimethoxysilane, and 3-[N-(2-aminoethyl)amino]propyltriethoxysilane, (amino C2-4 alkyl)aminodi C2-4 alkyldi C1-4 alkoxysilanes such as 3-[N-(2-aminoethyl)amino]propylmethyldimethoxysilane and 3-[N-(2-aminoethyl)amino]propylmethyldiethoxysilane], mercapto C2-4 alkyltri C1-4 alkoxysilanes such as alkoxysilanes having a mercapto group (2-mercaptoethyltrimethoxysilane, 3-mercaptopropyltrimethoxysilane, and 3-mercaptopropyltriethoxysilane, mercaptodi C2-4 alkyldi C1-4 alkoxysilanes) such as

3-mercaptopropylmethyldimethoxysilane and 3-mercaptopropylmethyldiethoxysilane, alkoxysilanes having a vinyl group (vinyltri C1-4 alkoxysilanes such as vinyltrimethoxysilane, and vinyltriethoxysilane), and alkoxysilanes having an ethylenic unsaturated bond group [(meth)acryloxy C2-4 alkyltri C1-4 alkoxysilanes such as 2-(meth)acryloxyethyltrimethoxysilane, 2-(meth)acryloxyethyltriethoxysilane, 3-(meth)acryloxypropyltrimethoxysilane, 3-(meth)acryloxypropyltriethoxysilane, (meth)acryloxydi C2-4 alkyldi C1-4 alkoxysilanes such as 3-(meth)acryloxypropylmethyldimethoxysilane and 3-(meth)acryloxypropylmethyldiethoxysilane). These silane coupling agents may be used alone or in combination of two or more thereof. Among these silane coupling agents, a silane coupling agent having an amino group is preferable.

The amount of the silicon-based cross-linking agent such as the silane coupling agent added to the protective layer is preferably 0.25 to 3.00% by mass, more preferably 0.5 to 2.75% by mass, and still more preferably 0.75 to 2.50% by mass. By the addition of the silane coupling agent, the curing of the film proceeds to improve the cohesive force, and as a result, a film having excellent water-resistant adhesiveness is obtained, and an effect of preventing the appearance of oligomers can also be expected. If the added amount exceeds 3.00% by mass, the curing of the film proceeds to provide an improved cohesive force, but an unreacted portion is also partially generated, which may cause deteriorated interlayer adhesiveness. Meanwhile, if the added amount is less than 0.25% by mass, a sufficient cohesive force may not be obtained.

(Polyester Resin)

A polyester resin used in the present invention is produced by polycondensation of a polycarboxylic acid component and a polyhydric alcohol component. The molecular weight of the polyester is not particularly limited as long as it can impart sufficient film toughness, coating suitability, and solvent solubility as a coating material, but is 1000 to 50000, and more preferably 1500 to 30000 in terms of number average molecular weight. The functional group at the polyester terminal is not particularly limited, and may have an alcohol terminal, a carboxylic acid terminal, or both the terminals. However, when an isocyanate-based curing agent is used in combination, it is necessary to use a polyester polyol mainly having an alcohol terminal.

[Glass Transition Temperature (Tg) of Polyester]

The Tg of the polyester used in the present invention needs to be 15°C or higher. This is because if the Tg is lower than the temperature, the resin has tackiness after the coating operation, which is apt to cause blocking to occur, resulting in a difficult winding operation after coating. This is because if the Tg of 15°C or lower makes it difficult to take measures for preventing blocking even under a situation where a pressure near a winding core is high due to the addition of an antiblocking material. The Tg is more preferably 18°C or higher, and still more preferably 25°C or higher.

The polyester used in the present invention is obtained by polycondensation of a polycarboxylic acid component and a polyhydric alcohol component.

[Polyvalent Carboxylic Acid Component]

The polycarboxylic acid component of the polyester used in the present invention contains at least one of an ortho-oriented aromatic dicarboxylic acid or an anhydride thereof. Ortho-orientation improves solubility in solvents and enables uniform coating on the substrate. A uniformly coated protective layer has less variation in barrier performance, and as a result, contributes to the suppression of oligo whitening. In addition, ortho-orientation makes the film more flexible and improves interfacial adhesion, which reduces damage to the substrate caused by wet heat treatment and leads to oligomer suppression. Examples of the aromatic polycarboxylic acid in which a carboxylic acid is substituted at an ortho position or an anhydride thereof include orthophthalic acid or an anhydride thereof, naphthalene 2,3-dicarboxylic acid or an anhydride thereof, naphthalene 1,2-dicarboxylic acid or an anhydride thereof, anthraquinone 2,3-dicarboxylic acid or an anhydride thereof, and 2,3-anthracene carboxylic acid or an anhydride thereof. These compounds may have a substituent at any carbon atom of the aromatic ring. The substituent includes chloro group, bromo group, methyl group, ethyl group, i-propyl group, hydroxyl group, methoxy group, ethoxy group, phenoxy group, methylthio group, phenylthio group, cyano group, nitro group, amino group, phthalimide group, and carboxyl group, carbamoyl group, N-ethylcarbamoyl group, phenyl group, or naphthyl group, etc. The polyester polyol having a content rate of 70 to 100 mol % with respect to all the components 100 mol % of the polycarboxylic acid is particularly preferable because the polyester polyol has a high effect of improving the barrier properties and excellent solvent solubility essential for the coating material.

The present invention may be copolymerized with another polycarboxylic acid component as long as the effect of the present invention is not impaired. Specifically, examples of the aliphatic polyvalent carboxylic acid include succinic acid, adipic acid, azelaic acid, sebacic acid, and dodecanedicarboxylic acid; examples of the unsaturated bond-containing polyvalent carboxylic acid include maleic anhydride, maleic acid, and fumaric acid; examples of the alicyclic polyvalent carboxylic acid include 1,3-cyclopentane dicarboxylic acid and 1,4-cyclohexanedicarboxylic acid; and examples of the aromatic polyvalent carboxylic acid include terephthalic acid, isophthalic acid, pyromellitic acid, trimellitic acid, 1,4-naphthalenedicarboxylic acid, 2,5-naphthalenedicarboxylic acid, 2,6-naphthalenedicarboxylic acid, naphthalic acid, biphenyldicarboxylic acid, diphenic acid and anhydrides thereof, 1,2-bis(phenoxy)ethane-p,p'-dicarboxylic acid, and anhydride or ester forming derivatives of these dicarboxylic acids; and polybasic acids such as p-hydroxybenzoic acid, p-(2-hydroxyethoxy)benzoic acid and ester-forming derivatives of these dihydroxycarboxylic acids can be used alone or in a mixture of two or more thereof. Among them, succinic acid, 1,3-cyclopentane dicarboxylic acid, isophthalic acid, 2,6-naphthalenedicarboxylic acid, 1,8-naphthalic acid, and diphenic acid are preferable from the viewpoint of the organic solvent solubility and the gas barrier properties.

[Polyhydric Alcohol Component]

The polyhydric alcohol component of the polyester used in the present invention is not particularly limited as long as it can synthesize a polyester exhibiting performance for gas barrier compensation, but it is preferable to contain a polyhydric alcohol component containing at least one selected from the group consisting of ethylene glycol, propylene glycol, butylene glycol, neopentyl glycol, cyclohexanedimethanol, and 1,3-bishydroxyethylbenzene. Among them, ethylene glycol is most preferably used as a main component because it is estimated that as the number of carbon atoms among the oxygen atoms is smaller, the molecular chain does not become excessively flexible and thus, oxygen permeation is less likely to occur.

As the present invention, it is preferable to use the above-described polyhydric alcohol component, but other polyhydric alcohol components may be copolymerized as long as the effect of the present invention is not impaired. Specifically, the diols include 1,5-pentanediol, 3-methyl-1,5-pentanediol, 1,6-hexanediol, methylpentanediol, dimethylbutanediol, butylethylpropanediol, diethylene glycol, triethylene glycol, tetraethylene glycol, dipropylene glycol, and tripropylene glycol, and alcohols that are trihydric or higher include glycerol, trimethylolpropane, trimethylol ethane, tris(2 -Hydroxyethyl) isocyanurate, 1,2,4-butantriol, pentaerythritol, and dipentaerythritol, etc. In particular, among trihydric alcohols, a polyester in which glycerol and tris(2-hydroxyethyl)isocyanurate are used in combination is derived from a branched structure, and has a moderately high cross-linking density, whereby the polyester has good organic solvent solubility and an excellent barrier function, which is particularly preferably used.

Examples of the catalyst used in the reaction for obtaining the polyester of the present invention include acid catalysts such as tin-based catalysts (such as monobutyl tin oxide and dibutyl tin oxide), titanium-based catalysts (such as tetra-isopropyl-titanate and tetra-butyl-titanate), and zirconia-based catalysts (such as tetra-butyl-zirconate). It is preferable to use a combination of the above-described titanium-based catalyst such as tetra-isopropyl-titanate or tetra-butyl-titanate, which has high activity for an ester reaction, and the above-described zirconia-based catalyst. As for the amount of the catalyst, the catalyst is used in an amount of 1 to 1000 ppm of the total mass of the reaction raw material to be used, and more preferably 10 to 100 ppm. If the amount is less than 1 ppm, the catalytic effect is less likely to be obtained, and if the amount is more than 1000 ppm, a problem that an urethanization reaction is inhibited may occur when an isocyanate curing agent is used.

In the present invention, when the polyester resin is used as the main agent of the coating agent constituting the protective layer, it is necessary to use an isocyanate-based curing agent as the curing agent to form a urethane resin. In this case, the coating layer becomes a cross-linking system, which provides an advantage that heat resistance, abrasion resistance, and rigidity are improved. Therefore, the laminated body is likely to be used for boiling and retort packaging. Meanwhile, there are also problems that the liquid cannot be reused after mixing the curing agent, and a curing (aging) step is required after coating.

When the polyester has a hydroxyl group, at least a part of the polyisocyanate compound used in the present invention reacts to form a urethane structure, thereby forming a highly-polar resin component. The highly-polar resin component causes the polymer chains to aggregate, which makes it possible to further enhance a gas barrier function. When the resin of the coating material is a linear resin, heat resistance and abrasion resistance can be imparted by cross-linking with a trivalent or higher polyisocyanate. The polyisocyanate compound used in the present invention may be any of a diisocyanate, a trivalent or higher polyisocyanate, a low molecular weight compound, and a polymer compound, but it is preferable that an aromatic ring or an aliphatic ring is contained in a part of the skeleton from the viewpoint of a gas barrier improving function. Examples of the isocyanate having an aromatic ring include toluene diisocyanate, diphenylmethane diisocyanate, xylylene diisocyanate, and naphthalene diisocyanate, and examples of the isocyanate having an aliphatic ring include hydrogenated xylylene diisocyanate, hydrogenated toluene diisocyanate, isophorone diisocyanate, norboron diisocyanate, trimers of these isocyanate compounds, and terminal isocyanate group-containing compounds obtained by reacting an excess amount of these isocyanate compounds with, for example, low molecular active hydrogen compounds such as ethylene glycol, propylene glycol, trimethylolpropane, glycerin, sorbitol, ethylenediamine, monoethanolamine, diethanolamine, and triethanolamine, or various polyester polyols, polyether polyols, and high molecular active hydrogen compounds such as polyamides.

The coating method of the resin composition for a protective layer is not particularly limited as long as it is a method of coating the film surface to form a layer. For example, normal coating methods such as gravure coating, reverse roll coating, wire bar coating, and die coating can be employed.

When the protective layer is formed, it is preferable to apply the resin composition for a protective layer and then heat and dry the resin composition, and the drying temperature at that time is preferably 110 to 190°C, more preferably 130 to 185°C, and still more preferably 150 to 180°C. If the drying temperature is lower than 110°C, insufficient drying may occur in the protective layer, or the formation of the protective layer does not proceed, whereby a cohesive force and water-resistant adhesiveness may be deteriorated, resulting in deterioration in barrier properties and hand tearability. Meanwhile, if the drying temperature exceeds 190°C, heat is excessively applied to the film, whereby the film may become brittle to cause a decreased puncture strength, or the film may shrink to cause deteriorated processability. In particular, by drying at 150°C or higher, and preferably 160°C or higher, the formation of the protective layer effectively proceeds, which provides a further increased adhesion area between the resin of the protective layer and the inorganic thin film layer, so that the water-resistant adhesiveness can be improved. If the solvent in the protective film is first volatilized under relatively low temperature conditions of 90°C to 110°C immediately after coating, and the protective film is then dried at 150°C or higher, a uniform film can be obtained, which is particularly preferable. In addition to drying, it is also more effective to perform additional heat treatment in a low temperature range as much as possible in order to advance the formation of the protective layer.

As described above, the laminated film of the present invention has excellent gas barrier performance before a treatment, can maintain its barrier property and adhesiveness even after a severe wet heat treatment, and uses a polyester resin derived from PET bottles with a less environmental load as a substrate to have less whitening after retorting.

[Packaging Material]

When the laminated film of the present invention is used as a packaging material, it is preferable to form a heat sealable resin layer called a sealant. The heat sealable resin layer is usually provided on the inorganic thin film layer, but may be provided on the outer side of the substrate film layer (the surface opposite to the surface on which the coating layer is formed). The heat sealable resin layer is usually formed by an extrusion lamination method or a dry lamination method. The thermoplastic polymer forming the heat sealable resin layer may be any thermoplastic polymer as long as it can sufficiently exhibit sealant adhesiveness, and polyethylene resins such as HDPE, LDPE, and LLDPE, polypropylene resins, ethylene-vinyl acetate copolymers, ethylene-$\alpha$-olefin random copolymers, and ionomer resins and the like can be used.

[Adhesive Layer]

For the adhesive layer used in the present invention, a general-purpose adhesive for lamination can be used. For example, it is possible to use solvent (free) type, aqueous type, and hot melt type adhesives containing poly(ester) urethane-based, polyester-based, polyamide-based, epoxy-based, poly(meth)acrylic-based, polyethyleneimine-based, ethylene-(meth)acrylic acid-based, polyvinyl acetate-based, (modified) polyolefin-based, polybutadiene-based, wax-based, and casein-based materials and the like as a main component. Among them, a urethane-based or polyester-based material is preferable in consideration of moist heat resistance that can withstand retorting and flexibility that can follow the dimensional changes of each substrate. As a method for laminating the adhesive layer, for example, the adhesive layer can be coated by a direct gravure coating method, a reverse gravure coating method, a kiss coating method, a die coating method, a roll coating method, a dip coating method, a knife coating method, a spray coating method, a fountain coating method, and other methods. The coated amount after drying is preferably 1 to 8 $g/m^2$ in order to exhibit sufficient adhesiveness after retorting. The coated amount is more preferably 2 to 7 $g/m^2$, and still more preferably 3 to 6 $g/m^2$. If the coated amount is less than 1 $g/m^2$, it is difficult to bond the film on the entire surface, whereby the adhesive force decreases. If the coated amount is more than 8 $g/m^2$ or more, it takes time to completely cure the film, and unreacted substances are apt to remain, whereby the adhesive force decreases.

Furthermore, in the laminated film of the present invention, at least one or more printed layers and other plastic substrates and/or paper substrates may be laminated between the inorganic thin film layer or the substrate film layer and the heat sealable resin layer, or on the outer side thereof.

As a printing ink for forming the printed layer, an aqueous or solvent-based resin-containing printing ink can be preferably used. Herein, examples of a resin used in the printing ink include an acrylic resin, a urethane-based resin, a polyester-based resin, a vinyl chloride-based resin, a vinyl acetate copolymer resin, and mixtures thereof. The printing ink may contain known additives such as an anti-static agent, a light blocking agent, an ultraviolet absorber, a plasticizer, a lubricant, a filler, a coloring agent, a stabilizer, a lubricant, an antifoaming agent, a cross-linking agent, an anti-blocking agent, and an antioxidant. The printing method of forming the printed layer is not particularly limited, and known methods such as an offset printing method, a gravure printing method, and a screen printing method may be used. For drying the solvent after printing, known drying methods such as hot wind drying, hot roll drying, and infrared drying may be used.

In the laminated body of the present invention, the standard deviation of the haze after retorting at 130°C for 30 minutes is preferably 0.5% or less. According to this range, the whitening unevenness of the film is not visible even after retorting, whereby a good appearance can be maintained. The reason is not clear, but in general, the intrinsic viscosity of a recycled resin derived from PET bottles is adjusted to a predetermined value by solid phase polymerization during resinification. Therefore, an oligomer amount tends to be smaller than that of a general film recovery resin. As a result, it is considered that the whitening of the film after retorting can be suppressed. Crystallization is suppressed by containing isophthalic acid, whereby a synergistic effect of suppressing the whitening can also be expected. Furthermore, in the case of a barrier film, a barrier layer suppresses the appearance of oligomers, whereby a greater effect can be expected. The haze standard deviation is preferably 0.4% or less, more preferably 0.35% or less, and still more preferably 0.3% or less. If the haze standard deviation is 0.5% or more, the appearance after retorting may be deteriorated, and when the oligomers are exposed, adhesion and barrier properties may be deteriorated, which is not preferable.

In the evaluation method of the haze standard, a laminated film having a size of 30 cm in a machine direction × 21 cm in a transverse direction is subjected to retorting at 130°C for 30 minutes, and surface moisture is then wiped off. Standard deviation is calculated using data obtained by measuring hazes at optional ten places with a haze meter.

The laminated body of the present invention preferably has an oxygen transmission rate of 10 $ml/m^2 \cdot d \cdot MPa$ or less under conditions of 23°C and 65% RH before and after retorting from the viewpoint of exhibiting good gas barrier properties. Furthermore, by controlling composition and adhesion amount of the inorganic thin film layer, the oxygen transmission rate can be set to preferably 7.5 $ml/m^2 \cdot d \cdot MPa$ or less, and more preferably 5 $ml/m^2 \cdot d \cdot MPa$ or less. The oxygen transmission rate exceeding 10 $ml/m^2 \cdot d \cdot MPa$ makes it difficult to cope with applications requiring high gas barrier properties. Meanwhile, if the oxygen transmission rate before and after retorting is less than 1 $ml/m^2 \cdot d \cdot MPa$ in any case, the barrier performance is excellent, but a residual solvent is less likely to outwardly permeate the bag, whereby the amount of the residual solvent transferred to the contents may relatively increase, which is not preferable. The lower limit of the oxygen transmission rate is preferably 1 $ml/m^2 \cdot d \cdot MPa$ or more.

The laminated body of the present invention preferably has a water vapor transmission rate of 2.0 $g/m^2 \cdot d$ or less under conditions of 40°C and 90% RH before and after retorting from the viewpoint of exhibiting good gas barrier properties. Furthermore, by controlling composition and adhesion amount of the inorganic thin film layer, the water vapor transmission rate can be set to preferably 1.5 $g/m^2 \cdot d$ or less, and more preferably 1.0 $g/m^2 \cdot d$ or less. The water vapor transmission rate exceeding 2.0 $g/m^2 \cdot d \cdot MPa$ makes it difficult to cope with applications requiring high gas barrier properties. Meanwhile, if the water vapor transmission rate before and after retorting is less than 0.1 $g/m^2$, the barrier performance is excellent, but a residual solvent is less likely to outwardly permeate the bag, whereby the amount of the residual solvent transferred to the contents may relatively increase, which is not preferable. The lower limit of the water vapor transmission rate is preferably 0.1 g/m$^2$·d or more.

The laminated body of the present invention preferably has a wet lamination strength of 1.0 N/15 mm or more, more preferably 1.5 N/15 mm or more, and still more preferably 2.0 N/15 mm or more under conditions of 23°C and 65% RH before and after retorting. If the lamination strength is less than 1.0 N/15 mm, peeling occurs due to a flexing load or liquid contents, whereby the barrier properties may be deteriorated, or the contents may leak. Furthermore, hand tearability may be deteriorated.

EXAMPLES

Hereinafter, the present invention will be described in more detail by way of Examples, but is not limited to the examples described below. Various evaluations were performed by the following measurement methods.

(1) Intrinsic Viscosity (IV) of Raw Material Resin and Resin Constituting Film

A sample was vacuum-dried at 130°C all day and all night, and then pulverized or cut. 80 mg of the obtained sample was accurately weighed, and heat-dissolved at 80°C for 30 minutes in a mixed solution of phenol/tetrachloroethane = 60/40 (volume ratio). The mixture was heat-dissolved at 80°C, and then cooled to normal temperature. The mixed solvent prepared at the above ratio was added in a measuring flask to adjust the total volume to 20 ml, followed by performing measurement at 30°C (unit: dl/g). An Ostwald viscometer was used to measure the intrinsic viscosity.

(2) Content Rate of Terephthalic Acid and Isophthalic Acid Components Contained in Raw Material Polyester and Polyester Constituting Film

A sample solution was prepared by dissolving a raw material polyester resin or a polyester film in a solvent in which chloroform D (manufactured by Yurisoppu Co., Ltd.) and trifluoroacetic acid D1 (manufactured by Yurisoppu Co., Ltd.) were mixed at 10 : 1 (volume ratio). Then, NMR of protons in the prepared sample solution was measured using an NMR apparatus (nuclear magnetic resonance analyzer: GEMINI-200 manufactured by Varian) under the measurement conditions of a temperature of 23°C and an integration number of 64. In the NMR measurement, the peak intensity of predetermined protons was calculated, and the content rates (mol%) of the terephthalic acid component and the isophthalic acid component in 100 mol% of acid components were calculated.

(3) Thicknesses of Substrate Film

The thicknesses of films were measured in accordance with JIS K7130-1999 A method using a dial gauge.

(4) Heat Shrinkage Rates of Substrate Film in Machine and Transverse directions

Sampling was carried out in a width of 10 mm in the substrate film and marked lines were put at 200 mm interval at room temperature (27°C). The interval of the marked lines (L0) was measured. Then, the film was sandwiched between papers, placed in a hot air oven controlled at a temperature of 150°C, and treated for 30 minutes. Thereafter, the sample was taken out, and the interval (L) of the marked lines was then measured to calculate a heat shrinkage rate from the following formula. Samples are collected for both a machine direction and a transverse direction.

$$\text{Heat shrinkage rate (\%)} = \{(L0 - L)/L0\} \times 100$$

(5) Refractive Index of Substrate Film in Thickness Direction

The refractive index (Nz) in the thickness direction was determined according to JIS K7142 using an Abbe's refractometer NAR-1T (manufactured by ATAGO Co., Ltd.). Sodium D ray was employed as a light source; a test piece having a refractive index of 1.74 was used; and methylene iodide was used as an intermediate liquid.

(6) Composition and Film Thickness of Inorganic Thin Film Layer

For laminated films (after lamination of thin films) obtained in Examples and Comparative Examples, a film thickness composition was measured by a calibration curve prepared in advance using an X-ray fluorescence analyzer ("ZSX100e" manufactured by Rigaku Corporation). The conditions of an excited X-ray tube were 50 kV and 70 mA.

(7) Adhesion Amount of Protective Layer

In each of Examples and Comparative Examples, each laminated film obtained at the stage of laminating a protective layer on a substrate film was used as a sample. A test piece of 100 mm × 100 mm was cut out from this sample. A protective layer was wiped with 1-methoxy-2-propanol or dimethylformamide. From a change in the mass of the film before and after wiping, the adhesion amount of the protective layer was calculated.

(8) Haze Standard Deviation after Retorting of Laminated Film

A laminated film having a size of 30 cm in a machine direction × 21 cm in a transverse direction was subjected to retorting at 130°C for 30 minutes, and surface moisture was then wiped off. Hazes were measured at optional ten places with a haze meter NDH-2000 (manufactured by Nippon Denshoku Industries Co., Ltd.), and standard deviation was calculated using the obtained data.

[Production of Laminated Bodies]

A nylon film ("N1100" manufactured by Toyobo Co., **Ltd.) having a thickness of 15 μm was bonded onto the** laminated body obtained in each of Examples and Comparative Examples by a dry lamination method using a urethane-based two-liquid-component curable adhesive ("Takelac (registered trademark) A525S" manufactured by Mitsui Chemicals, Inc. and "Takenate (registered trademark) A50") were blended at a ratio of 13.5 : 1 (mass ratio)). Then, a non-stretched polypropylene film ("P1146" manufactured by Toyobo Co., **Ltd.) having a thickness of 70 μm as a heat sealable resin** layer was bonded onto the nylon film by a dry lamination method using the same urethane-based two-liquid-component curable adhesive as described above. The resultant was aged at 40°C for 4 days to obtain a gas barrier laminated body for evaluation (hereinafter, sometimes referred to as "laminated body A"). Each of the thicknesses of the adhesive layers formed of the urethane based two-liquid-**component curable adhesive after drying was about 4 μm.**

(9) Method for Evaluating Oxygen Transmission Rate

The normal oxygen transmission rate of the laminated body produced in the above [Production of Laminated Bodies] was measured in an atmosphere of a temperature of 23°C and a humidity of 65% RH using an oxygen transmission rate measurement apparatus ("OX-TRAN (registered trademark) 1/50" manufactured by MOCON) in accordance with JIS-K7126 B method. The oxygen transmission rate was measured in a direction in which oxygen permeated from the substrate film side to the heat sealable resin layer side of the laminated body.

Meanwhile, the laminated body produced in the above [Production of Laminated Bodies] was subjected to a wet heat treatment in which the laminated body was held in hot water at 120°C for 30 minutes, and dried at 40°C for 1 day (24 hours). The oxygen transmission rate (after retorting) of the obtained laminated body after the wet heat treatment was measured in the same manner as described above.

(9) Method for Evaluating Water Vapor Transmission Rate

For the laminated bodies produced in the above [Production of Laminated Bodies], the normal water vapor transmission rate was measured in an atmosphere of a temperature of 40°C and a humidity of 90% RH using a water vapor transmission rate measurement apparatus ("PERMATRAN-W 3/33 MG" manufactured by MOCON) in accordance with JIS-K 7129 B method. The water vapor transmission rate was measured in a direction in which water vapor permeated from the heat sealable resin layer side of the laminated body toward the substrate film side.

Meanwhile, the laminated body produced in the above [Production of Laminated Bodies] was subjected to a wet heat treatment in which the laminated body was held in hot water at 120°C for 30 minutes, and dried at 40°C for 1 day (24 hours). The water vapor transmission rate (after retorting) of the obtained laminated body after the wet heat treatment was measured in the same manner as described above.

(10) Method for Evaluating Lamination Strength

The laminated body produced above was cut into a test piece having a width of 15 mm and a length of 200 mm, and a lamination strength (normal state) was measured using a Tensilon universal material testing machine ("Tensilon UMT-11-500 type" manufactured by Toyo Baldwin Co., Ltd.) under the conditions of a temperature of 23°C and a relative humidity of 65%. In the measurement of a lamination strength, a tensile speed was set to 200 mm/min, and a strength was measured when water was applied between the laminated film layer and the heat sealable resin layer of each of the laminated films obtained in Examples and Comparative Examples, and peeling was performed at a peeling angle of 90 degrees.

Meanwhile, the laminated body produced as described above was subjected to retorting for 30 minutes in which the laminated body was held in pressurized hot water at a temperature of 120°C. Immediately thereafter, a test piece was cut out from the obtained laminated body after retorting in the same manner as described above, and a lamination strength (after retorting) was measured in the same manner as described above.

Hereinafter, coating liquids used in the present Examples and Comparative Examples will be described in detail. The coating liquids were used in Examples 1 to 11 and Comparative Example 1 to 4, and shown in Table 1.

[Carbodiimide-Based Cross-Linking Agent (A)]

As a carbodiimide-based cross-linking agent, commercially available "Carbodilite (registered trademark) SV-02" manufactured by Nisshinbo Chemical Inc.; solid content: 40%) was prepared.

[Oxazoline Group-Containing Resin (B)]

As an oxazoline group-containing resin, commercially available water-soluble oxazoline-group-containing acrylate ("EPOCROS (registered trademark) WS-300" manufactured by Nippon Shokubai Co., Ltd.; solid content: 10%) was prepared. The oxazoline group amount in this resin was 7.7 mmol/g.

[Acrylic Resin (C)]

As an acrylic resin, a commercially available acrylic ester copolymer emulsion having a concentration of 25% by mass ("Movinyl (registered trademark) 7980" manufactured by Nichigo-Movinyl Co. Ltd.) was prepared. The acid value (theoretical value) of the acrylic resin was 4 mgKOH/g.

[Urethane Resin (D)]

As a urethane resin, a commercially available polyester urethane resin dispersion ("Takelac (registered trademark) W605" manufactured by Mitsui Chemicals, Inc., solid content: 30%) was prepared. This urethane resin had an acid value of 25 mgKOH/g, and a glass transition temperature (Tg) of 100°C, which was measured by DSC. The proportion of its aromatic or aromatic-aliphatic diisocyanates was 55 mol% of the whole of its polyisocyanate components, the proportion being measured by 1H-NMR.

[Silane Coupling Agent (E)]

As a silane coupling agent, commercially available "KBM903 (registered trademark)" manufactured by Shin-Etsu Chemical Co., Ltd., solid content 100%) was prepared. In use, the silane coupling agent was diluted with water to obtain a 2% aqueous solution.

[Urethane Resin (F)]

In a four-neck flask equipped with a stirrer, a Dimroth condenser, a nitrogen introducing pipe, a silica gel drying pipe, and a thermometer, 143.95 parts by mass of methaxylylene diisocyanate, 25.09 parts by mass of 4,4'-methylenebis(cyclohexyl isocyanate), 28.61 parts by mass of ethylene glycol, 5.50 parts by mass of trimethylolpropane, 12.37 parts by mass of dimethylolpropionic acid, and 120.97 parts by mass of methyl ethyl ketone as a solvent were mixed. The mixture was stirred at 70°C under a nitrogen atmosphere to confirm that the reaction solution had reached a predetermined amine equivalent. Next, the temperature of the reaction solution was decreased to 35°C, and 9.14 parts by mass of triethylamine was then added to the reaction solution to obtain a polyurethane prepolymer solution. Next, 794.97 parts by mass of water was added to a reaction vessel equipped with a homodisper allowing highspeed stirring, and the temperature was adjusted to 15°C. The polyurethane prepolymer solution was added thereto and dispersed in the water while stirred and mixed at 2000 min-1. An amine aqueous solution obtained by mixing 22.96 parts by mass of 2-[(2-aminoethyl)amino]ethanol and 91.84 parts by mass of water was added thereto, and then an amine aqueous solution obtained by mixing 2.38 parts by mass of N-2-(aminoethyl)-3-aminopropyltrimethoxysilane (product name; KBM-603 manufactured by Shin-Etsu Chemical Co., Ltd.) and 9.50 parts by mass of water was added thereto to perform a chain extension reaction. Thereafter, methyl ethyl ketone and a part of water were removed under reduced pressure to obtain a polyurethane dispersion (E) having a solid content of 25% by mass and an average particle diameter of 70 nm. The Si content (according to charge calculation) of the obtained polyurethane dispersion (D-1) was 1200 mg/1 kg, and the methaxylylene group content (according to charge calculation) was 32% by mass.

[Polyester Resin (G)]

As a polyester component, a polyester polyol ("DF-COAT GEC-004C" manufactured by DIC Corporation, solid content: 30%) was used.

[Polyisocyanate Cross-Linking Agent (H)]

As a polyisocyanate component, a trimethylolpropane adduct of metaxylylene diisocyanate ("Takenate D-110N" manufactured by Mitsui Chemicals, Inc., solid content: 75%) was used.

[Silane Coupling Agent (I)]

As a silane coupling agent, N-2-(aminoethyl)-3-aminopropyltrimethoxysilane ("KBM-603" manufactured by Shin-Etsu Chemical Co., Ltd.) was used.

[Gas Barrier Vinyl Alcohol-Based Resin (J)]

As a vinyl alcohol-based resin having gas barrier properties, a commercially available water-soluble vinyl alcohol resin ("Nichigo G-Polymer (registered trademark) OKS-8049" manufactured by The Nippon Synthetic Chemical Industry Co., Ltd.; powder) was dissolved in water to prepare an aqueous solution having a solid content of 5%.

[Coating Liquid 1 used for Coating Layer]

Materials were mixed at the following blending ratio to prepare a coating liquid (resin composition for coating layer).

| | |
|---|---|
| Water | 54.40% by mass |
| Isopropanol | 25.00% by mass |
| Oxazoline group-containing resin (A) | 15.00% by mass |
| Acrylic resin (B) | 3.60% by mass |
| Urethane resin (C) | 2.00% by mass |

[Coating Liquid 2 used for Coating Layer]

Materials were mixed at the following blending ratio to prepare a coating liquid (resin composition for coating layer).

| | |
|---|---|
| Water | 57.80% by mass |
| Isopropanol | 25.00% by mass |
| Carbodiimide-based cross-linking agent (A) | 2.10% by mass |
| Urethane resin (F) | 8.00% by mass |
| Silane coupling agent (E) | 7.10% by mass |

[Coating Liquid 3 Used for Coating of Protective Layer]

Coating agents described below were mixed with each other to prepare a coating liquid 3.

| | |
|---|---|
| Water | 22.00% by mass |
| Isopropanol | 30.00% by mass |
| Urethane resin (F) | 48.00% by mass |

[Coating Liquid 4 Used for Coating of Protective Layer]

A solution (15% by weight) obtained by dissolving the silane coupling agent (I) in acetone and the isocyanate (G) were mixed at the following ratio, and the mixture was stirred for 10 minutes using a magnetic stirrer. The resulting prepared liquid was diluted with methyl ethyl ketone, and the polyester resin (G) was further added to obtain a coating liquid. The mixing ratio is shown below.

| | |
|---|---|
| Polyester resin (G) | 4.90% by mass |
| Isocyanate (H) | 1.87% by mass |
| Silane coupling agent (I) * acetone diluted solution | 0.85% by mass |
| Methyl ethyl ketone | 92.39% by mass |

[Coating Liquid 5 Used for Coating of Protective Layer]

Coating agents described below were mixed with each other to prepare a coating liquid 5.

| | |
|---|---|
| Water | 20.00% by mass |
| Isopropanol | 10.00% by mass |
| Gas Barrier Vinyl Alcohol-Based Resin (J) | 70.00% by mass |

Hereinafter, a method for producing a laminated film used in each of Examples and Comparative Examples will be described. The laminated films were used in Examples 1 to 11 and Comparative Example 1 to 4, and shown in Table 1.

(Preparation of Polyester Resin Recycled from PET Bottles)

A recycled polyester raw material was obtained by washing PET bottles for beverages to remove foreign matters such as remaining beverage, thereafter melting flakes obtained by pulverizing the PET bottles by an extruder, further changing the filter with a filter having a smaller mesh size, then separating the fine foreign matters by filtration twice, and then separating the fine foreign matters by third filtration using a filter with the **smallest mesh size of 50 μm. The obtained resin had a** composition of terephthalic acid/isophthalic acid//ethylene glycol = 97.0/3.0//100 (mol%), and the intrinsic viscosity of the resin was 0.70 dl/g. This resin was defined as a polyester A.

(Production of Substrate Film)

A substrate film was produced using a polyethylene terephthalate resin made of terephthalic acid//ethylene glycol = 100//100 (mol%) as a polyester B and having an intrinsic viscosity of 0.62 dl/g, and a master batch containing, as a polyester C, the polyester B and 0.3% of amorphous silica having an average particle diameter of 1.5 **μm. The respective raw materials were dried at 125°C under** reduced pressure of 33 Pa for 8 hours. A mixture obtained by mixing these raw materials so that A/B/C became 70/20/10 (weight ratio) was charged into a single screw extruder. The resin temperature was set to 280°C from the extruder to a melt line, a filter, and a T-die. The resin temperature was set to 305°C for 30 seconds from the starting point of a compression part of a screw of the extruder, and thereafter to 280°C again.

The melt extruded out of the T-die was brought into close contact with a cooling roll to obtain an un-stretched sheet. Then, the un-stretched sheet was stretched (MD1) 1.41 times in the machine direction with rolls heated to 118°C and having different circumferential speeds, and further stretched (MD2) 2.92 times in the machine direction with rolls heated to 128°C and having different circumferential speeds. The vertically stretched sheet was introduced to a tenter, and one surface of the film was coated with the coating liquid 1 by a fountain bar coating method. The sheet was introduced to the tenter while being dried, preheated at 121°C, and thereafter transversely stretched 4.3 times at 131°C. Then, for heat setting, the sheet was subjected to a treatment at 180°C without relaxation (0%) for 2.5 seconds (TS1), thereafter to a treatment at 231°C with 5% of relaxation for 3.0 seconds (TS2), and further to a treatment at 222°C without relaxation for 2.5 seconds (TS3). Then, the sheet was cooled in the same tenter at 120°C for 6.0 seconds, and finally wound with a winder to obtain a biaxially stretched

**polyester film having a thickness of 12 μm.**

Laminated films were similarly produced and evaluated except that the blending amounts of the resins A, B, and C or the coating liquids of the coating layer as shown in Table 1 were changed in preparing the substrate film layers described in Examples and Comparative Examples.

Hereinafter, a method for producing an inorganic thin film layer used in each of Examples and Comparative Examples will be described. The inorganic thin film layers were used in Examples 1 to 9 and Comparative Examples 1 to 9, and shown in Table 1.

(Formation of Inorganic Thin Film Layer M-1)

As an inorganic thin film layer M-1, aluminum oxide was vapor-deposited on the substrate film layer. In the method of vapor-depositing aluminum oxide on the substrate film layer, a film is set on the unwinding side of a continuous type vacuum vapor-deposition apparatus, caused to travel via a cooling metal drum, and wound. At this time, the pressure of the continuous type vacuum vapor-deposition apparatus was reduced to 10-4 Torr or less. Metal aluminum having a purity of 99.99% was loaded in a crucible made of alumina from the lower portion of the cooling drum. The metal aluminum was heated and evaporated. While oxygen was supplied into the vapor to perform an oxidization reaction, aluminum oxide was deposited onto the film to form an aluminum oxide film having a thickness of 10 nm.

<Formation of Inorganic Thin Film Layer M-2>

As an inorganic thin film layer M-2, a composite oxide layer of silicon dioxide and aluminum oxide was formed on a substrate film layer by an electron beam vapor-deposition method. Particulate $SiO_2$ (purity: 99.9 %) and $Al_2O_3$ (purity: 99.9%) having a size of about 3 mm to 5 mm were used as a vapor-deposition source. The film thickness of the inorganic thin film layer ($SiO_2/Al_2O_3$ composite oxide layer) in the film (inorganic thin film layer/coating layer-containing film) obtained as described above was 13 nm. The composition of the composite oxide layer was $SiO_2/Al_2O_3$ (mass ratio) = 60/40.

(5) Coating of Coating Liquid 3 on Vapor-Deposited Film (Lamination of Protective Layer)

The coating liquid 3 prepared above was applied onto the inorganic thin film layer of the obtained vapor-deposited film by a gravure roll coating method, preliminarily dried at 110°C, and then sufficiently dried at 160°C to obtain a protective layer. The coating amount after drying was 0.15 g/m² (Dry). Thereafter, a post-heat treatment was performed at 40°C for 2 days. The coating liquid comprising the protective layer, the sufficiently dried temperature described above, and post-heat treatment conditions were changed as shown in Table 1 of each of the examples and comparative examples.

As described above, laminated films including the coating layer, the inorganic thin film layer, and the protective layer on the substrate film was produced. The obtained laminated films were subjected to evaluations. The results are shown in Table 1.

[Table 1]

| | Substrate film | | Coating layer | | Inorganic thin film layer | | Protective layer | | | | Evaluation item | | | | | | | | | | |
| | Content rate of resin recycled from PET bottles [%] | Thickness [µm] | Type | Adhesion amount [g/m²] | Type | Thickness [nm] | Type | Drying temperature [°C] | Post-heat after coating | Adhesion amount [g/m²] | Substrate film Heat Shrinkage Rates [%] Machine direction | Transverse direction | Refractive Index in Thickness Direction [%] | Standard deviation of the haze after retorting [%] | Oxygen Transmission Rate [ml/m²·day·MPa] Before treatment | after retorting | Laminated body A Water Vapor Transmission Rate [g/m²·day] Before treatment | after retorting | Lamination Strength [N/15mm] Before treatment | after retorting |
|---|---|---|---|---|---|---|---|---|---|---|---|---|---|---|---|---|---|---|---|---|
| Example 1 | 60 | 12 | - | - | M-1 | 10 | Coating liquid 3 | 160 | 40°C×2 days | 0.15 | 1.2 | 0.1 | 1.4952 | 0.40 | 5.8 | 5.9 | 0.5 | 1.1 | 4.1 | 3.1 |
| Example 2 | 70 | 12 | - | - | M-1 | 10 | Coating liquid 3 | 160 | 40°C×2 days | 0.15 | 1.3 | 0.2 | 1.4955 | 0.36 | 5.4 | 5.7 | 0.5 | 1.0 | 4.2 | 2.9 |
| Example 3 | 80 | 12 | - | - | M-1 | 10 | Coating liquid 3 | 160 | 40°C×2 days | 0.15 | 1.1 | 0.1 | 1.4959 | 0.23 | 5.0 | 5.0 | 0.5 | 1.1 | 3.9 | 3.1 |
| Example 4 | 80 | 9 | - | - | M-1 | 10 | Coating liquid 3 | 160 | 40°C×2 days | 0.15 | 1.0 | 0.1 | 1.4959 | 0.23 | 5.0 | 5.0 | 0.5 | 1.1 | 4.1 | 2.8 |
| Example 5 | 80 | 18 | - | - | M-1 | 10 | Coating liquid 3 | 160 | 40°C×2 days | 0.15 | 0.8 | 0.5 | 1.4955 | 0.23 | 5.0 | 5.0 | 0.5 | 1.1 | 4.0 | 2.7 |
| Example 6 | 90 | 12 | - | - | M-1 | 10 | Coating liquid 3 | 160 | 40°C×2 days | 0.15 | 0.9 | 0.1 | 1.4956 | 0.21 | 5.2 | 4.9 | 0.5 | 1.1 | 4.0 | 2.9 |
| Example 7 | 90 | 12 | - | - | M-1 | 10 | Coating liquid 3 | 160 | None | 0.15 | 0.9 | 0.1 | 1.4956 | 0.33 | 5.2 | 6.4 | 0.5 | 1.3 | 4.0 | 2.5 |
| Example 8 | 90 | 12 | - | - | M-1 | 10 | Coating liquid 3 | 140 | 40°C×2 days | 0.15 | 0.9 | 0.1 | 1.4956 | 0.35 | 5.9 | 6.5 | 0.5 | 1.2 | 4.0 | 2.3 |
| Example 9 | 80 | 12 | Coating | 0.03 | M-1 | 10 | Coating | 160 | 40°C×2 days | 0.15 | 0.7 | 0.1 | 1.4956 | 0.32 | 4.5 | 4.8 | 0.5 | 0.7 | 4.1 | 3.0 |

| | | | | | | | | | | | | | | | | | | | | |
|---|---|---|---|---|---|---|---|---|---|---|---|---|---|---|---|---|---|---|---|---|
| Example 10 | 80 | 12 | Coating liquid 1 | 0.03 | M-2 | 13 | Coating liquid 4 | 190 | 40°C×4 days | 0.30 | 0.7 | 0.1 | 1.4956 | 0.33 | 2.5 | 2.2 | 0.4 | 0.6 | 4.1 | 3.0 |
| Example 11 | 80 | 12 | Coating liquid 2 | 0.04 | M-2 | 13 | Coating liquid 4 | 190 | 40°C×4 days | 0.30 | 0.9 | 0.2 | 1.4956 | 0.28 | 3.1 | 3.7 | 0.3 | 0.8 | 4.1 | 3.0 |
| Comparative Example 1 | 0 | 12 | - | - | M-1 | 10 | Coating liquid 3 | 160 | 40°C×2 days | 0.15 | 1.4 | -0.3 | 1.4972 | 1.02 | 9.0 | 8.0 | 0.8 | 1.0 | 4.4 | 3.3 |
| Comparative Example 2 | 0 | 12 | - | - | M-2 | 13 | Coating liquid 4 | 190 | 40°C×4 days | 0.30 | 1.4 | -0.3 | 1.4972 | 1.27 | 2.2 | 2.5 | 0.5 | 0.8 | 4.1 | 3.0 |
| Comparative Example 3 | 80 | 12 | - | - | M-1 | 10 | Coating liquid 5 | 160 | - | 0.15 | 1.2 | 0.1 | 1.4969 | 1.54 | 2.0 | 20.0 | 0.2 | 4.0 | 0.9 | 0.1 |
| Comparative Example 4 | 80 | 12 | - | - | M-1 | 10 | - | - | - | - | 1.3 | 0.1 | 1.4955 | 0.48 | 20.0 | 54.0 | 1.5 | 2.6 | 4.8 | 4.3 |

INDUSTRIAL APPLICABILITY

According to the present invention, the present inventors have found that by forming a laminated film having a constitution in which an inorganic thin film layer is sandwiched between specific coating layers or specific barrier protective layers having excellent flexibility and adhesiveness, gas barrier performance before a treatment can be improved, and the barrier properties and adhesiveness of the laminated film can be maintained even after a severe wet heat treatment. The present inventors further have found that the use of a polyester resin derived from PET bottles having a low environmental load as a substrate provides less whitening after retorting, and have completed the present invention. Moreover, the laminated film of the present invention provides few processing steps, and can be easily produced, whereby a gas barrier film excellent in both economic efficiency and production stability and having homogeneous characteristics can be provided.

**Claims**

1.  A laminated film comprising:

    a substrate film;
    an inorganic thin film layer on at least one surface of the substrate film; and
    a protective layer containing a urethane resin on the inorganic thin film layer,
    wherein the laminated film satisfies the following requirements (a) to (c):

    (a) the substrate film contains 50% by weight or more of a polyester resin recycled from PET bottles;
    (b) standard deviation of a haze after retorting the laminated film at 130°C for 30 minutes is 0.5% or less; and
    (c) an adhesion amount of the protective layer is 0.5 g/m$^2$ or less.

2.  The laminated film according to claim 1,
    wherein the protective layer contains an aromatic component or an aromatic-aliphatic component as a constituent component.

3.  The laminated film according to claim 1 or 2,
    wherein the protective layer contains a meta-xylylene diisocyanate component as a constituent component.

4.  The laminated film according to any one of claims 1 to 3, further comprising a coating layer between the substrate film layer and the inorganic thin film layer,
    wherein the coating layer contains a resin having an oxazoline group or a carbodiimide group as a constituent component.

5.  The laminated film according to any one of claims 1 to 4, wherein the inorganic thin film layer is an aluminum oxide layer or a layer of a composite oxide of silicon oxide and aluminum oxide.

6.  A packaging material obtained by laminating a sealant layer on one surface of the laminated film according to any one of claims 1 to 5.

**INTERNATIONAL SEARCH REPORT**

| | International application No. |
|---|---|
| | PCT/JP2020/041936 |

A. CLASSIFICATION OF SUBJECT MATTER
B32B 9/00(2006.01)i; B32B 27/36(2006.01)i; B32B 27/40(2006.01)i; B65D 65/02(2006.01)i; B65D 65/40(2006.01)i; B65D 81/34(2006.01)i
FI: B32B9/00 A ZAB; B32B27/36; B32B27/40; B65D65/02 E; B65D65/40 D; B65D81/34 P

According to International Patent Classification (IPC) or to both national classification and IPC

B. FIELDS SEARCHED

Minimum documentation searched (classification system followed by classification symbols)
B32B9/00; B32B27/36; B32B27/40; B65D65/02; B65D65/40; B65D81/34

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-7175 A (TOYOBO CO., LTD.) 12 January 2017 (2017-01-12) claims, paragraphs [0063], [0064], example 1 | 1, 5<br>2-4, 6 |
| X<br>Y | JP 2019-18410 A (DAINIPPON PRINTING CO., LTD.) 07 February 2019 (2019-02-07) claims, paragraphs [0026], [0033], [0045]-[0055], [0068]-[0071], [0107]-[0109], [0131], [0135], drawings | 1-3, 5-6<br>2-4, 6 |
| Y | WO 2017/126563 A1 (TOYOBO CO., LTD.) 27 July 2017 (2017-07-27) claims, paragraphs [0064], [0065], examples | 4 |
| Y | JP 2011-224981 A (TOYOBO BOSEKI KABUSHIKI KAISHA) 10 November 2011 (2011-11-10) claims, paragraphs [0016], [0021], [0022], examples | 4 |

| ☐ Further documents are listed in the continuation of Box C. | ☒ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 January 2021 (06.01.2021) | 19 January 2021 (19.01.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

INTERNATIONAL SEARCH REPORT

Information on patent family members

International application No.

PCT/JP2020/041936

| Patent Documents referred in the Report | Publication Date | Patent Family | Publication Date |
|---|---|---|---|
| JP 2017-7175 A | 12 Jan. 2017 | (Family: none) | |
| JP 2019-18410 A | 07 Feb. 2019 | (Family: none) | |
| WO 2017/126563 A1 | 27 Jul. 2017 | EP 3406421 A1 claims, paragraphs [0097], [0098], examples CN 108472860 A KR 10-2018-0108670 A TW 201736453 A | |
| JP 2011-224981 A | 10 Nov. 2011 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012091862 A
- JP 6500629 B
- JP 5560708 B
- JP 4524463 B